Europäisches Patentamt

European Patent Office

Office européen des brevets

(11) Veröffentlichungsnummer: **0 047 392**
**B1**

# (12) EUROPÄISCHE PATENTSCHRIFT

(45) Veröffentlichungstag der Patentschrift:
**20.11.86**

(21) Anmeldenummer: **81105991.4**

(22) Anmeldetag: **30.07.81**

(51) Int. Cl.⁴: **H 01 L 27/06**, H 01 L 29/78,
**H 03 K 17/00**

(54) **Hochvolt-Halbleiterschalter.**

(30) Priorität: **25.08.80 US 181290**

(43) Veröffentlichungstag der Anmeldung:
**17.03.82 Patentblatt 82/11**

(45) Bekanntmachung des Hinweises auf die Patenterteilung:
**20.11.86 Patentblatt 86/47**

(84) Benannte Vertragsstaaten:
**DE FR GB IT NL**

(56) Entgegenhaltungen:
**FR - A - 2 422 258**

**IEEE TRANSACTIONS ON ELECTRON DEVICES, Band ED-18, Nr. 8, August 1971, Seiten 525-527 BRANT T. JOHNSON: "The epi channel switch"**
**IBM TECHNICAL DISCLOSURE BULLETIN, Band 22, Nr. 12, Mai 1980, Seiten 5296-5297, New York, USA D.M. KENNEY: "Bipolar erase technique in EPROM VMOS devices"**

(73) Patentinhaber: **Deutsche ITT Industries GmbH, Hans-Bunte-Strasse 19 Postfach 840, D-7800 Freiburg (DE)**

(84) Benannte Vertragsstaaten: **DE**

(73) Patentinhaber: **ITT INDUSTRIES INC., 320 Park Avenue, New York, NY 10022 (US)**

(84) Benannte Vertragsstaaten: **FR GB IT NL**

(72) Erfinder: **Pernyeszi, Joseph, 43 Mayflower Circle, Fairfield Connecticut (US)**

(74) Vertreter: **Morstadt, Volker, Dipl.-Ing., c/o Deutsche ITT Industries GmbH Patent/Lizenzabteilung Postfach 840 Hans-Bunte-Strasse 19, D-7800 Freiburg/Brsg. (DE)**

**Beschreibung**

Die vorliegende Erfindung betrifft einen integrierten Hochvolt-Halbleiterschalter mit bipolaren und VMOS bzw. DMOS-Transistoren, vgl. z.B. IEEE Transactions on Electron Devices, Vol. ED-18, No. 8, 1971, Seiten 525–527.

Aus der US-PS 41 70 740 ist ein Hochvolt-Halbleiterschalter sowie ein Element zur kapazitiven Spannungsübertragung bekannt, die zwei VMOS-Transistoren als Schaltelemente enthalten. In Abhängigkeit der Spannung und des Stromes, die von dem Bauelement verarbeitet werden, sind die in diesem verwendeten VMOS-Transistoren bezüglich ihrer Leistung auszuwählen. Die Schaltung nach dem genannten Patent dient als Ersatz für ein Relais und die VMOS-Transistoren sollten deshalb einen niedrigen «Ein»-Widerstand besitzen. Bei Hochvolt-Halbleiterbauelementen besitzen die aus dem Stand der Technik bekannten VMOS-Transistorschaltelemente einen hohen Widerstandswert und ein verhältnismässig dickes Substrat aus n-leitendem Halbleitermaterial ist zu verwenden, damit entsprechend Platz für die Verarmungsschichten gegeben ist und damit das elektrische Feld ausreichend unter dem kritischen Wert gehalten wird. Der Widerstand des n-leitenden Materials dieser bekannten VMOS-Transistoren ist ein wesentlicher Teil des «Ein»-Widerstandes, ist damit verhältnismässig hoch und verursacht auf diese Weise eine Verschlechterung der Schalteigenschaften dieser VMOS-Transistoren nach dem Stand der Technik.

Der Erfindung liegt die Aufgabe zugrunde, einen Hochvolt-Halbleiterschalter mit einem parasitären pnp-Transistor zu schaffen, dessen Basisstrom von der Drainzone eines MOS-Transistors vom VMOS-Typ oder DMOS-Typ geliefert wird. Die Aufgabe wird durch die im kennzeichnenden Teil der Ansprüche 1 und 11 angeführten Merkmale gelöst.

Durch die vorliegende Erfindung wird ein Hochvolt-Halbleiterschalter geschaffen, der eine Halbleiterzone vom n-Leitungstyp enthält, die gleichzeitig als Drain-Zone eines MOS-Transistors und als Basis eines pnp-Transistors dient. Diese beiden Transistoren haben den gleichen Basis- und Drainstrom. Eine erste $p^+$-leitende Zone in der n-leitenden Zone dient einerseits als Kollektor oder Emitter des pnp-Transistors, während eine von dieser Zone in einem bestimmten Abstand liegende zweite $p^+$-leitende Zone in der n-leitenden Zone andererseits den Emitter bzw. den Kollektor des pnp-Transistors darstellt. Eine zwischen der ersten und zweiten $p^+$-leitenden Zone in der n-leitenden Zone angeordnete p-leitende Zone stellt das Gate des MOS-Transistors dar, während eine $n^+$-leitende Zone in der p-leitenden Zone als Source-Zone des MOS-Transistors dient.

Die Erfindung wird anhand der beigefügten Zeichnung näher erläutert. Darin ist

Fig. 1 die schematische Darstellung eines Hochvolt-Halbleiterschalters nach der vorliegenden Erfindung, der einen VMOS-Transistor enthält,

Fig. 2 eine schematische Darstellung eines abgewandelten Hochvolt-Halbleiterschalters nach Fig. 1,

Fig. 3 das zu den Fig. 1 und 2 gehörende Schaltbild,

Fig. 4 eine schematische Darstellung eines Hochvolt-Halbleiterschalters nach der vorliegenden Erfindung, der einen DMOS-Transistor enthält,

Fig. 5 das der Fig. 4 entsprechende Schaltbild.

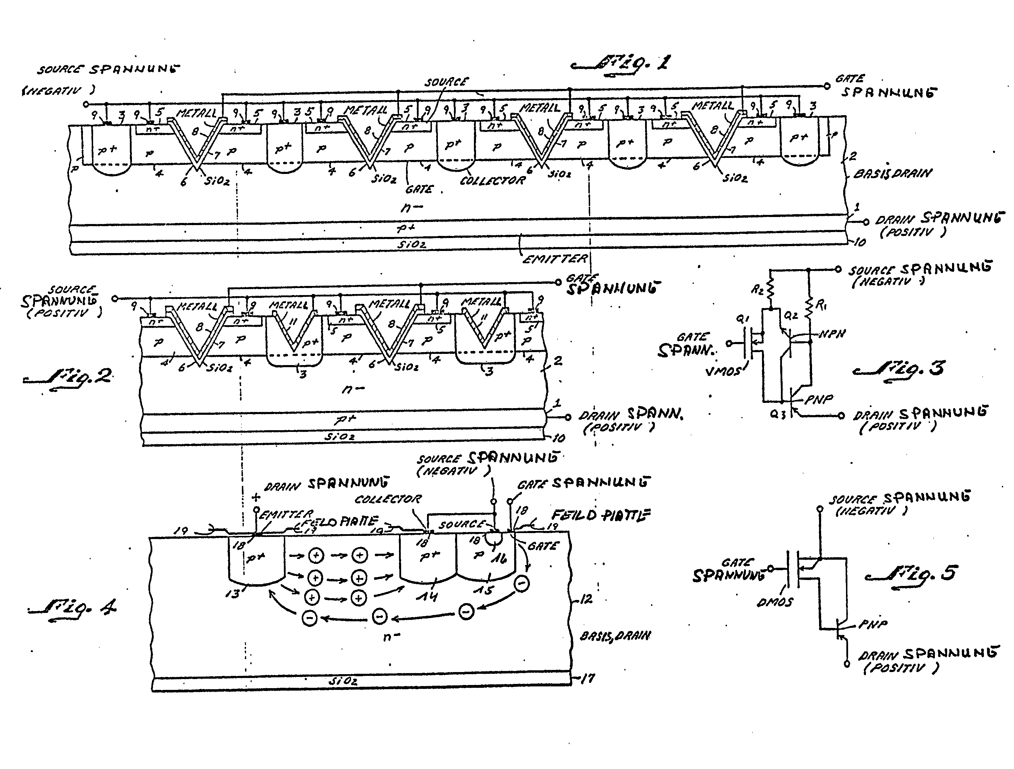

Fig. 1 zeigt einen Hochvolt-Halbleiterschalter vom VMOS-Typ mit einer $p^+$-dotierten Schicht 1. Grundsätzlich enthält der Schalter einen parasitären pnp-Transistor, wobei sein Emitter aus der Schicht 1, seine Basis aus dem $n^-$-dotierten Halbleitersubstrat 2 und sein Kollektor durch die eindiffundierten, $p^+$-dotierten Halbleiterzonen 3 gebildet wird. Der VMOS-Transistor besteht aus dem Halbleitersubstrat 2 als Drain-Zone, der p-leitenden Halbleiterzone 4 als Steuerelektrode und der $n^+$-leitenden Halbleiterzone 5 als Sourcezone. Die Schicht 1 und die Zonen 3 bis 5 werden nach der bekannten doppelten Diffusionstechnik hergestellt.

Zwischen den einzelnen Zonen 3 liegt in der Zone 4 jeweils ein Einschnitt 6, der bis in das Substrat 2 reicht und den bekannten V-förmigen Kanal eines VMOS-Transistors bildet. Jeder der Einschnitte 6 ist mit einer Halbleiteroxidschicht überzogen, die wiederum von einer Metallkontaktschicht 8 abgedeckt ist, an der die Gatespannung liegt. Die Zonen 3 und 5 sind über deren Oberflächenkontakte 9 mit der negativen Sourcespannung verbunden.

Die Schicht 1 ist mit einer Oxidschicht aus Halbleitermaterial wie z.B. Siliciumdioxid ($SiO_2$) bedeckt. Das gleiche Oxid kann als Beschichtung 7 in den V-förmigen Kontakten verwendet werden.

Bei der in Fig. 2 gezeigten Modifikation der Fig. 1 sind die Metallkontakte 9 der Zone 3 durch V-förmige Metallkontakte 11 ersetzt.

Aus den Fig. 1 und 2 lassen sich folgende Erkenntnisse ableiten.

(1) Das Halbleitersubstrat 2 ist sowohl die Drain-Zone des VMOS-Transistors wie die Basiszone des pnp-Transistors, so dass der Drainstrom des VMOS-Transistors der Basisstrom des pnp-Transistors wird.

Die Basis des pnp-Transistors, also das Halbleitersubstrat 2 ist gleichmässig dotiert, d.h. es bildet sich in ihr kein Feld.

(3) Die V-förmigen Kontakte 11 der Fig. 2 in der Zone 3 setzen den Spannungsabfall auf ein Minimum herab, der den Gate-Source-Übergang des VMOS-Transistors vorspannen könnte.

Fig. 3 zeigt das Schaltbild eines Hochvolt-Halbleiterschalters nach den Fig. 1 und 2, es enthält einen VMOS-Transistor Q1 und einen pnp-Transistor Q3 sowie einen npn-Transistor Q2. Der Transistor Q2 ist in den Fig. 1 und 2 derart ausgebildet, dass die Zone 5 auf der einen Seite der Zone 3 als sein Emitter, die Zone 5 auf der anderen Seite der Zone 3 als seine Basis und die Zone 3 selbst als sein Kollektor wirkt. Die Transistoren Q2 und Q3 können gegebenenfalls von einem Zustand in den anderen schalten, bei entsprechender Ausbildung kann jedoch der Widerstand R1 (der Widerstandswert der Zone 2) so klein gehalten werden, dass der Spannungsabfall an ihm unter 0,6 V liegt, dem Wert, der die Einschaltspannung für die Basis des Transistors Q2 ist. Der Emitter-Basis-Durchbruch des Transistors Q3 entspricht etwa seinem Kollektor-Basis-Durchbruch. Deshalb wirkt der Transistor Q3 als Diode sofern auf die Sourcespannung bezogen die Drainspannung negativ ist.

Im folgenden wird eine Reduktion beschrieben, die die praktische Anwendung des VMOS-Hochvolt-Halbleiterschalters nach den Fig. 1 und 2 darstellt, wobei deren Betrieb zur Erreichung einer Verringerung des «Ein»-Widerstandes des Hochvolt-Halbleiterschalters nach der vorliegenden Erfindung gezeigt wird.

Ausgangsmaterial: 20 Ohm/cm, N-Typ, $\langle 100 \rangle$, $2/10^{14}$ 1/cm³, up = 400 cm²/Vs, $\tau_p$ = 15 µs, Dp = 10.4 cm²/s, LD = $\sqrt{Dp\ \tau p}$ = $\sqrt{10.4 . 15 . 10^{-6}}$ = 124.

Es ist anzunehmen dass der pnp-Transistor in dem Bereich hoher Injektion arbeitet und der Dp-Wert in der Gleichung für den Transportwirkungsgrad dem doppelten des Gleichgewichtswertes entspricht.

$$\beta^{\chi} = \frac{1}{ch\ \dfrac{W}{LD}} = \frac{1}{ch\ \dfrac{38}{258}} = 0.9892 \qquad (1)$$

Obige Annahme wird durch Berechnung der Stromdichte und Vergleich der Dichte der injizierten Löcher mit dem Gleichgewicht der Elektronendichte bestätigt.

$$P_n \approx \left[ (1-\gamma)\ \frac{Sn}{Sp+W}\ \frac{Ln}{} - 1 \right] N_D = \left[ (1-0.95)\ \frac{20.1.73 \cdot 10^{-3}}{0.31 \cdot 38 \cdot 10^{-4}} - 1 \right] \cdot 2 \cdot 10^{-14} = 8.9 \cdot 10^{15}\ 1/cm^3 \qquad (3)$$

Dieses Ergebnis liegt um zwei Grössenordnungen über dem Gleichgewicht der Elektronendichte und bestätigt die Annahmen, die für einen hohen Injektionspegel gemacht wurden.

Der Kollektorstrom kann nun ausgedrückt werden als Ableitung der Löcherdichte, abgenommen am Kollektor-Basis-Übergang.

$$I_c = AgDp\ \frac{dp}{dx}\Big|_{x=w} \qquad (3A)$$

Dies bedeutet ein Bauelement mit 1.235 mm Kantenlänge. Fügt man 2 um an allen Seiten hinzu, so erhält man eine Kantenlänge von 1,341 mm. Gemäss Fig. 1 entspricht dies einer Breite von 54

Die p$^+$-dotierte Schicht 1 ist hochdotiert und bildet so eine Übergangsstufe mit dem n$^-$-dotierten Halbleitersubstrat 2. Diese Annahme kann als zutreffend angesehen werden, obgleich das Profil tatsächlich einer Gauss-Verteilung entspricht. Da aber das Dotierniveau der Schicht 1 um so viel höher ist als das der Schicht 2, ist der Übergangsbereich sehr kurz, so dass der Übergang wie eine Stufe wirkt.

Die vergrabene Schicht besitzt folgende Charakteristik:

0.01 Ohm/cm, P Type, $10^{19}$, Dn = 2.5 cm²/s, $\tau n$ = 1.2 µs LN = $\sqrt{DN\ \tau n}$ = $\sqrt{1.2.10^{-6}\ 2.5}$ = 1.73 $10^{-7}$ cm = 17 µm.

Die Zahl für den Widerstandswert ist der schlechtmöglichste Wert überhaupt. Er wird niedrig angesetzt, um dem Hochtemperaturprozess Rechnung zu tragen, der sich der Diffusion der vergrabenen Schicht anschliesst.

Mit den obigen Werten und einer niedrigen Grenze der Verstärkung wird die maximale Stromdichte erneut berechnet, wobei man von Bedingungen für einen hohen Injektionspegel ausgeht.

$$\gamma \approx 1 - \frac{In}{Ip} = 1 - \frac{Sp + W}{Sn - Ln}\left( 1 + \frac{Pn^-}{N_D} \right) \qquad (2)$$

Die Grenze von $v \geq 0,95$ ist sinnvoll, da dann $h_{FE}$ = 20. Der Maximalstrom, bei dem das Bauelement noch zu handhaben ist, übersteigt 120 mA nicht. Aus Gleichung (2)

Unter Vernachlässigung der Rekombination und der Annahme einer hohen Injektion ergibt sich

$$I_{PE} = AgDp\ \frac{P}{W} \qquad (3B)$$

Daraus kann der Emitter-Basis-Übergangsbereich, der die genaue Stromdichte angibt, wie folgt ausgedrückt werden.

$$A = \frac{PE}{AgDpP} = \frac{0.12 \cdot 38 \cdot 10^{-4}}{1.6 \cdot 10^{-19}\ 20.8 \cdot 8.9 \cdot 10^{15}} = 1.54 \cdot 10^{-2}\ cm^2 \qquad (4)$$

× 1242 um des V-Kanals 6. Unter Anwendung des gegenwärtigen Diffusionsschemas von BTM für VMOS-Transistoren mit geringer Oxidstärke für den Kanalwiderstand erhält man

$$R_{ch} = \frac{1}{\beta(V_G - V_T)} = \frac{1}{K\dfrac{W}{L}(V_G - V_T)} = \frac{1}{5\dfrac{67068}{3.67}(10^{-2})} = 1 \cdot 368\ Ohm \qquad (5)$$

Dieser Wert liegt in einer Reihe mit dem Widerstandswert der Drainzone. Dieser Wert lässt sich aus den Parameters des schwach n-dotierten Ausgangsmaterials unter Verwendung der Geometrie der Fig. 1 und unter Berücksichtigung der ungleichmässigen Stromverteilung berechnen. An der Spitze des Einschnittes 6 liegt eine Oberflächenanreicherungsschicht. Die vom Kanal kommenden Elektronen enden plötzlich in dieser Schicht und können von dort in das schwach n-dotierte Halbleitersubstrat 2 emittiert werden. Der Einfachheit wegen wird seine Form angenähert als Halbzylinder angenommen. Somit ist der Widerstand der n-leitenden Schicht etwas von der Stärke der Schicht 2 unabhängig. Es gilt

$$R_1 = \frac{S}{l\pi} \ln \frac{r}{r_o} = \frac{20}{6.7\pi} \ln \frac{11.5}{1.5} = 1.93 \text{ Ohm} \quad (6)$$

worin 1 die Kanalbreite, $r_o$ der Radius des Halbzylinders und r der halbe Abstand zwischen den Einschnitten ist.

Der Rest des Widerstandswertes des Halbleitersubstrats 2 ist der Widerstand des Abschnittes, der sich von r bis zur Schicht 1 in der Länge und vom Mittelpunkt des einen Kontakteinschnittes bis zum Mittelpunkt des nächsten erstreckt. Es gilt

$$R_2 = \frac{S(w-r)}{IL} = \frac{20(40-11.5)10^{-4}}{6.7\,23\cdot10^{-4}} = 3.69 \text{ Ohm} \quad (7)$$

worin w die Dicke des Halbleitersubstrats 2 und L der Abstand zwischen den zwei Kontaktgräben 6 ist.

Aus den Gleichungen ergibt sich der Gesamtwiderstand des Halbleitersubstrats 2 als

$$R_{n-} = R_1 + R_2 = 1.93 + 3.69 = 5.62 \text{ Ohm}$$

Diese Gleichung schliesst den Effekt der Leitfähigkeitsmodulation nicht ein, so kann sie nur als schlechte Annäherung der Berechnung des «Ein»-Widerstandes angesehen werden. Der gesamte «Ein»-Widerstand des VMOS-Transistors ist die Summe aus den Widerständen des Kanals und der Masse.

$$R_{ON} = R_{ch} + R_{n-} = 1.36 = 5.62 = 6.98 \text{ Ohm} \quad (8)$$

Dieser Wert ist durch die Stromverstärkung des parasitären pnp-Transistors zu teilen.

Die Diffusionsschritte sind die gleichen wie die beim BTM-Verfahren, sieht man von der p-dotierten Gate-Schicht ab, wo einige Abwandlungen notwendig sein können, wobei gleichzeitig die Gateoxidstärke verringert wird, um eine Schwellspannung von 2 V zu erreichen. Herabsetzen der Schwellspannung senkt den «Ein»-Widerstand. Dieser Effekt ist signifikant, da die Leitfähigkeitsmodulation, die in dem $n^-$-dotierten Halbleitersubstrat 2 stattfindet, deren Widerstandswert senkt. Der Widerstand bzw. die Leitfähigkeit hängt ab von der Dichte der Minoritätsträger. Nachdem dabei die Basis des Transistors eine Rolle spielt, variiert die Verteilung der Minoritätsträger und mit ihr der spezifische Widerstand. Der spezifische Widerstand lässt sich als Funktion der Dichte der injizierten Träger ausdrücken. Es gilt

$$S_{n-}^1 = S_{n-} \frac{1}{1+\dfrac{P}{N_D}} \quad (9)$$

Setzt man (9) in (7) ein, so erhält man

$$R2 = \int_o^w \frac{S_{n-}^1 \, dx}{IL} = S_{n-} \int_o^w \frac{dx}{(1+\dfrac{P}{N_D})IL} \quad (10)$$

Als Obergrenze wurde W eingesetzt, da die Löcherverteilung unabhängig von der lateralen Koordinate und damit die Stromdichte gleichmässig ist.

Unter Verwendung der Gleichungen (3b) lässt sich Po wie folgt ausdrücken

$$P_o = \frac{Iw}{AgDp} \quad (11)$$

Nimmt man an, dass P für den Kollektorübergang Null wird und eine lineare Funktion darstellt, so gilt

$$P = P_o\left(1-\frac{x}{W}\right) = \frac{IW}{AgDp}\left(1-\frac{x}{W}\right) \quad (12)$$

worin x gleich Null der Emitter-Basis-Übergang ist.

Setzt man (12) in (10) und integriert, so erhält man

$$R_2 = \frac{S_{n-}}{ILI} AgDpN_D \ln \frac{(1+IW)}{AgDpN_D} = \frac{20\cdot1.54\cdot10^{-2}\,1.6\cdot10^{-19}\,20.8\cdot2\cdot10^{14}}{6.7\cdot23\cdot10^{-4}\,0.12} \quad (13)$$

$$\ln(1+ \frac{0.12\cdot38\cdot10^{-4}}{1.54\cdot10^{-2}\,16\cdot10^{-19}\,20.82\cdot10^{14}} = 0.423 \text{ Ohm}$$

Teilt man diesen Wert durch die Verstärkung des pnp-Transistors, so liegt der «Ein»-Widerstand bei ca. 0.02 Ohm. Fig. 4 zeigt einen Hochvolt-Halbleiterschalter nach der Erfindung unter Verwendung eines DMOS-Transistors. Bei dem Schalter vom DMOS-Typ ist ein lateraler pnp-Transistor an der Oberfläche des $n^-$-dotierten Halbleitersubstrats 12 ausgebildet, der die $p^+$-leitenden Halbleiterzonen 13 und 14 einschliesst, wobei, wie aus Fig. 4 ersichtlich, die Zone 13 den Emitter, die Zone 14 den Kollektor und das Halbleitersubstrat 12 die Basis des pnp-Transistors bilden. Der DMOS-Transistor in dem Bauelement nach Fig. 4 ist wie folgt aufgebaut: Das Halbleitersubstrat 12 wirkt als Drain-Zone, die p-leitende Halbleiterzone 15, eindiffundiert in das Halbleitersubstrat 12 an der gleichen Oberfläche desselben wie die Zonen 13 und 14, stellt die Gate-Elektrode dar und die $n^+$-dotierte Halbleiterzone 16, eindiffundiert in die Zone 15, wirkt als Source. Eine Halbleiteroxidschicht 17 ist auf der Oberfläche des Halbleitersubstrats 12 gegenüber der die Zonen 13 bis 16 enthaltenden Fläche angeordnet. Die Zonen 13 bis 16 sind jeweils mit Metallkontakten 18 versehen, wobei an diese eine Feldplatte 19 angeschlossen ist, um die Durchbruchspannung in dem Bauteil zu erhöhen.

Der Schalter nach Fig. 4 besitzt einen niedrigen «Ein»-Widerstand und besitzt die Fähigkeit, hohe Stromstärken zu übertragen. Der Elektronenfluss (−) induziert einen Fluss an positiven Ladungen (Löchern in der umgekehrten Richtung). Die gezeigte Geometrie des Schalters nach Fig. 4 ist so, dass der Fluss der Löcher und der Elektronenfluss voneinander getrennt sind und somit die Löcher in die gewünschte Zone 14 gelangen.

Fig. 5 zeigt das dem Bauteil nach Fig. 4 entsprechende Schaltbild, man erkennt, dass der pnp-Transistor und der DMOS-Transistor die gleichen Basis- und Drainströme aufweisen entsprechend dem Halbleitersubstrat 12 in Fig. 4, wobei dieses die Basis des pnp-Transistors und die Drain-Zone des DMOS-Transistors bildet.

**Patentansprüche**

1. Integrierter Hochvolt-Halbleiterschalter mit VMOS- und bipolaren Transistoren, gekennzeichnet durch folgende Merkmale:
– ein $n^-$-dotiertes Halbleitersubstrat (2), das sowohl als Drainzone der VMOS-Transistoren als auch als Basis von pnp-Transistoren dient, wobei der Basisstrom der pnp-Transistoren und der Drainstrom der MOS-Transistoren einander gleich sind,
– eine p-dotierte Halbleiterzone (4) in dem Halbleitersubstrat (2), in der die V-förmigen Gate-Bereiche angeordnet sind,
– $p^+$-dotierte Halbleiterzonen (3), die sich durch die p-dotierte Halbleiterzone (4) hindurch bis zum Substrat (2) erstrecken und als Kollektor bzw. Emitter des pnp-Transistors dienen,
– eine auf der der p-dotierten Halbleiterzone (4) gegenüberliegenden Seite des Halbleitersubstrats angeordnete $p^+$-dotierte Halbleiterschicht (1), die als Emitter bzw. als Kollektor des pnp-Transistors dient,

– $n^+$-dotierte Zonen in der p-dotierten Halbleiterzone (4), die als Source-Zonen für VMOS-Transistoren dienen.

2. Halbleiterschaltung nach Anspruch 1, gekennzeichnet durch eine gleichmässige Störstellenverteilung in dem $n^-$-dotierten Halbleitersubstrat (2).

3. Halbleiterschalter nach Anspruch 2, dadurch gekennzeichnet, dass das Halbleitersubstrat (2) dicker ist als die anderen Zonen und somit sein Widerstand in erster Linie den «Ein»-Widerstand des Halbleiterschalters bestimmt.

4. Halbleiterschalter nach einem der Ansprüche 1 bis 3, dadurch gekennzeichnet, dass der V-förmige Gate-Bereich jeweils aus einem V-förmigen Einschnitt (6) besteht, der von der Oberfläche der p-dotierten Halbleiterzone (4) in das $n^-$-dotierte Halbleitersubstrat (2) reicht, wobei eine Halbleiteroxidschicht (7) die Oberfläche des V-förmigen Einschnitts (6) überdeckt und auf ihr eine Metallkontaktschicht (8) aufgebracht ist.

5. Halbleiterschalter nach Anspruch 4, dadurch gekennzeichnet, dass das Halbleiteroxid Siliciumdioxid ist.

6. Halbleiterschalter nach Anspruch 4 oder 5, dadurch gekennzeichnet, dass eine $n^+$-dotierte Zone (5) zu beiden Seiten des V-förmigen Einschnitts (6) im Abstand zum $n^-$-dotierten Halbleitersubstrat (2) in die p-dotierte Halbleiterzone (4) eindiffundiert ist.

7. Halbleiterschalter nach Anspruch 6, dadurch gekennzeichnet, dass auf jeder $n^+$-dotierten Halbleiterzone (5) ein metallener Oberflächenkontakt angeordnet ist.

8. Halbleiterschalter nach einem der Ansprüche 1 bis 7, dadurch gekennzeichnet, dass auf jeder $p^+$-dotierten Halbleiterzone (3) ein metallener Oberflächenkontakt angeordnet ist.

9. Halbleiterschalter nach Anspruch 8, dadurch gekennzeichnet, dass die metallenen Oberflächenkontakte V-förmige Metallkontakte (11) sind.

10. Halbleiterschalter nach einem der Ansprüche 1 bis 9, dadurch gekennzeichnet, dass die $p^+$-dotierte Schicht (1) mit Siliciumdioxid (10) abgedeckt ist.

11. Hochvolt-Halbleiterschalter mit DMOS- und bipolaren Transistoren, gekennzeichnet durch folgende Merkmale:
– ein $n^-$-dotiertes Halbleitersubstrat (12), das sowohl als Drainzone der DMOS-Transistoren als auch als Basiszone der pnp-Transistoren dient, wobei der Basisstrom der pnp-Transistoren und der Drainstrom der DMOS-Transistoren der gleiche ist,
– $p^+$-dotierte Halbleiterzonen (13, 14), die sich von der einen Hauptfläche des Halbleitersubstrats (12) in dieses hinein erstrecken und als Emitter bzw. Kollektor des pnp-Transistors dienen,
– eine an die $p^+$-dotierte Halbleiterzone (14) sich anschliessende p-dotierte Halbleiterzone (15), die als Gate des DMOS-Transistors dient,
– eine in die p-dotierte Halbleiterzone (15) eindiffundierte $n^+$-dotierte Halbleiterzone (16), die als Source des DMOS-Transistors dient.

12. Halbleiterschalter nach Anspruch 11, dadurch gekennzeichnet, dass eine Halbleiteroxidschicht (17) auf der Oberfläche des Halbleitersubstrats (12) gegenüber der die Zonen (13 bis 16) enthaltenden Fläche angeordnet ist und dass die Zonen (13 bis 16) jeweils mit Metallkontakten (18) versehen sind, an die eine Feldplatte (19) angeschlossen ist.

## Claims

1. High-voltage integrated semiconductor switch comprising VMOS and bipolar transistors, characterized by the following features:
- an n⁻ type semiconductor substrate (2) providing both a drain region for the VMOS transistors and a base for pnp transistors, with the base current of the pnp transistors and the drain current of the MOS transistors being equal to each other;
- a p type semiconductor region (4) disposed in the semiconductor substrate (2) and containing the V-shaped gate regions;
- p⁺ type semiconductor regions (3) extending through the p type semiconductor region (4) to the substrate (2) and providing a collector and an emitter for the pnp transistor;
- a p⁺ type semiconductor layer (1) disposed on the side of the semiconductor substrate opposite the p type semiconductor region (4) and providing an emitter and a collector for the pnp transistor, and
- n⁺ type regions disposed in the p type semiconductor region (4) and providing source regions for VMOS transistors.

2. A semiconductor switch as claimed in claim 1 characterized by a uniform impurity distribution in the n⁻ type semiconductor substrate (2).

3. A semiconductor switch as claimed in claim 2, characterized in that the semiconductor substrate (2) is thicker than the other regions such that its resistance primarily determines the ON resistance of the semiconductor switch.

4. A semiconductor switch as claimed in any one of claims 1 to 3, characterized in that each V-shaped gate region includes a V-shaped groove (6) extending from the surface of the p type semiconductor region (4) into the n⁻ type semiconductor substrate (2), a layer of semiconductor oxide (7) disposed to coat the surface of the V-shaped groove (6), and a metal contact layer (8) covering the semiconductor oxide layer.

5. A semiconductor switch as claimed in claim 4, characterized in that the semiconductor oxide is silicon dioxide.

6. A semiconductor switch as claimed in claim 4 or 5, characterized in that on both sides of the V-shaped groove (6), an n⁺ type semiconductor region (5) is diffused in the p type semiconductor region (4) remote from the n⁻ type semiconductor substrate (2).

7. A semiconductor switch as claimed in claim 6, characterized in that each of the n⁺ type semiconductor regions (5) has a metal surface contact disposed thereon.

8. A semiconductor switch as claimed in any one of claims 1 to 7, characterized in that each of the p⁺ type semiconductor regions (3) has a metal surface contact disposed thereon.

9. A semiconductor switch as claimed in claim 8, characterized in that the metal surface contacts are V-shaped metal contacts (11).

10. A semiconductor switch as claimed in any one of claims 1 to 9, characterized in that the p⁺ type layer (1) is covered with silicon dioxide (10).

11. High-voltage semiconductor switch comprising DMOS and bipolar transistors, characterized by the following features:
- an n⁻ type semiconductor substrate (12) providing both a drain region for the DMOS transistors and a base region for the pnp transistors, with the pnp transistors and the DMOS transistors having the same base and drain current;
- p⁺ type semiconductor regions (13, 14) extending from one main surface of the semiconductor substrate (12) into the latter and providing, respectively, an emitter and a collector for the pnp transistor;
- a p type semiconductor region (15) adjoining the p⁺ type semiconductor region (14) and providing a gate for the DMOS transistor, and
- an n⁺ type semiconductor region (16) diffused in the p type semiconductor region (15) and providing a source for the DMOS transistor.

12. A semiconductor switch as claimed in claim 11, characterized in that a semiconductor oxide layer (17) is provided on the surface of the semiconductor substrate (12) opposite the surface containing the regions (13 to 16), and that the regions (13 to 16) are each provided with metallic contacts (18) having a field plate (19) connected thereto.

## Revendications

1. Commutateur à semi-conducteur intégré à haute tension comprenant des transistors VMOS et bipolaires, caractérisé en ce qu'il comprend:
- un substrat semi-conducteur (2) à dopage n⁻ servant de zone de drain pour les transistors VMOS en même temps que de base pour les transistors pnp, de sorte que le courant de base des transistors pnp et le courant de drain des transistors VMOS soient égaux entre eux,
- une zone de semi-conducteur à dopage p (4) aménagée dans le substrat semi-conducteur (2), dans laquelle se trouvent les structures de grilles forme de V,
- des zones de semi-conducteur à dopage p⁺ (3) s'étendant à travers la zone de semi-conducteur à dopage p (4) jusqu'au substrat (2), servant de collecteur ou d'émetteur aux transistors pnp,
- une couche de semi-conducteur à dopage p⁺ (1) disposée sur le côté du substrat semi-conducteur opposé à celui qui porte la zone de semi-conducteur à dopage p (4), servant d'émetteur ou de collecteur aux transistors pnp,
- des zones à dopage n⁺ disposées dans la zone de semi-conducteur à dopage p (4), servant de zones de source pour les transistors VMOS.

2. Commutateur à semi-conducteur selon la revendication 1, caractérisé en ce que le substrat semi-conducteur (2) à dopage n⁻ est uniformément dopé.

3. Commutateur à semi-conducteur selon la revendication 2, caractérisé en ce que le substrat semi-conducteur (2) est plus épais que les autres zones de sorte que sa résistance détermine principalement la résistance à l'état conducteur du commutateur.

4. Commutateur à semi-conducteur selon l'une des revendications 1 à 3, caractérisé en ce que les structures de grille en forme de V comprennent chacune une saignée (6) en forme de V s'étendant depuis la surface de la zone de semi-conducteur à dopage p (4) jusque dans le substrat semi-conducteur (2) à dopage n⁻, de sorte qu'une couche (7) d'oxyde semi-conducteur recouvre la surface de la saignée (6) en forme de V, sur laquelle est disposée une couche de contact métallique (8).

5. Commutateur à semi-conducteur selon la revendication 4, caractérisé en ce que l'oxyde semi-conducteur est du dioxyde de silicium.

6. Commutateur à semi-conducteur selon la revendication 4 ou 5, caractérisé en ce qu'une zone à dopage n⁺ (5) est diffusée dans la zone de semi-conducteur à dopage p (4), depuis la zone de substrat semi-conducteur (2) à dopage n⁻ et s'étend de chaque côté de la saignée (6) en forme de V.

7. Commutateur à semi-conducteur selon la revendication 6, caractérisé en ce que, sur chaque zone de semi-conducteur à dopage n⁺ (5) est disposée une surface de contact métallique.

8. Commutateur à semi-conducteur selon l'une quelconque des revendications 1 à 7, caractérisé en ce que, sur chaque zone de semi-conducteur à dopage p⁺ (3) est disposée une surface de contact métallique.

9. Commutateur à semi-conducteur selon la revendication 8, caractérisé en ce que les surfaces de contact métallique sont des contacts métalliques (11) en forme de V.

10. Commutateur à semi-conducteur selon l'une quelconque des revendications 1 à 9, caractérisé en ce que la couche à dopage p⁺ (1) est recouverte de dioxyde de silicium.

11. Commutateur à semi-conducteur à haute tension comprenant des transistors DMOS et bipolaires, caractérisé en ce qu'il comprend:
   – un substrat semi-conducteur à dopage n⁻ (12) servant de zone de drain des transistors DMOS, en même temps que de zone de base des transistors pnp, de sorte que le courant de base des transistors pnp et le courant de drain des transistors DMOS est le même,
   – des zones de semi-conducteur à dopage p⁺ (13, 14) s'étendant dans le substrat semi-conducteur (12), depuis la surface de celui-ci, servant d'émetteur ou de collecteur aux transistors pnp,
   – une zone de semi-conducteur à dopage p (15) associée à la zone de semi-conducteur à dopage p⁺ (14) servant de grille à un transistor DMOS,
   – une zone de semi-conducteur à dopage n⁺ (16) diffusée dans la zone de semi-conducteur à dopage p (15) servant de source à un transistor DMOS.

12. Commutateur à semi-conducteur selon la revendication 1, caractérisé en ce qu'une couche d'oxyde semi-conducteur (17) est disposée sur la surface du substrat semi-conducteur (12) opposée à celle qui contient lesdites zones (13 à 16) et en ce que lesdites zones (13 à 16) sont pourvues chacune d'un contact métallique (18) auquel est reliée une plaque de champ (19).

SOURCE SPANNUNG (NEGATIV)

_Fig. 1_

GATE SPANNUNG

SOURCE

METALL  METALL  METALL  METALL

n+  p+  p  SiO2  GATE  COLLECTOR  SiO2  BASIS DRAIN

n−

p+

SiO2

EMITTER

DRAIN SPANNUNG (POSITIV)

SOURCE SPANNUNG (POSITIV)

GATE SPANNUNG

_Fig. 2_

METALL  METALL  METALL  METALL

n+  p  SiO2  n−  p+

p+

SiO2

DRAIN SPANN. (POSITIV)

SOURCE SPANNUNG (NEGATIV)

R2  R1

GATE SPANN.  Q1  Q2  NPN

VMOS  PNP  Q3

_Fig. 3_

DRAIN SPANNUNG (POSITIV)

DRAIN SPANNUNG  SOURCE SPANNUNG (NEGATIV)  GATE SPANNUNG

EMITTER  FIELD PLATTE  COLLECTOR  SOURCE  FEILD PLATTE  GATE

p+  p+  p

n−

BASIS, DRAIN

SiO2

_Fig. 4_

SOURCE SPANNUNG (NEGATIV)

GATE SPANNUNG  DMOS  PNP

_Fig. 5_

DRAIN SPANNUNG (POSITIV)

0 047 392